# EUROPÄISCHE PATENTSCHRIFT

(11) **EP 0 305 708 B1**
(45) Veröffentlichungstag und Bekanntmachung des Hinweises auf die Patenterteilung: **11.01.1995**
(21) Anmeldenummer: 88111444.1
(22) Anmeldetag: 15.07.1988
(51) Int. Cl.: H03H 17/06

(54) **Digitales Dezimierungsfilter**
Digital decimating filter
Filtre numérique à décimation

(30) Priorität: 01.09.1987 DE 3729172
(43) Veröffentlichungstag der Anmeldung: 08.03.1989
(73) Patentinhaber: SIEMENS AKTIENGESELLSCHAFT, 80333 München (DE)
(72) Erfinder: Meier, Stefan, Dipl.-Ing., D-8000 München 83 (DE); Noll, Tobias, Dipl.-Ing., D-8056 Neufahrn (DE)

(56) Entgegenhaltungen:
- Y. TSIVIDIS et al.: "Design of MOS VLSI circuits for telecommnucations", 1985,Seiten 236-271, Prentice Hall, New York, US; "MOS digitalfilter design"
- ELECTRONICS INT., Band 50, Nr. 20, 29. September 1977, Seiten 93-99, New York,US; S. WASER et al.: "Real-time processing gains ground with fast digital multiplier"
- I.E.E.E. TRANSACTIONS ON CONSUMER ELECTRONICS, Band CE-33, Nr. 3., August 1987,
- Seiten 129-134, IEEE, New York, US; I.A. SHAH et al.: "A fast multiplierless architecture for general purpose VLSI FIR digital filters"

## Beschreibung

Die Erfindung bezieht sich auf ein digitales Dezimierungsfilter nach dem Oberbegriff des Patentanspruchs 1.

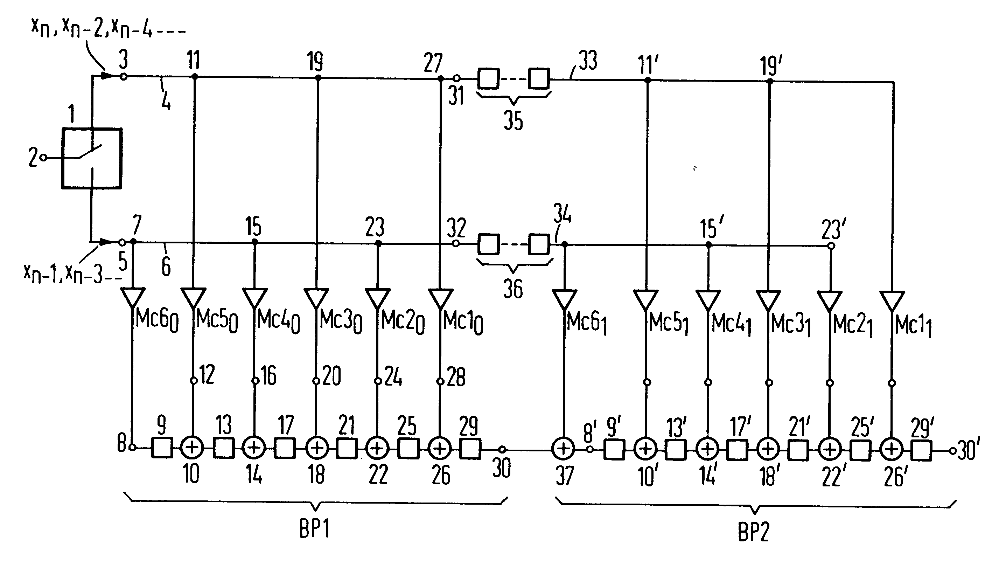

Ein solches Dezimierungsfilter für feste Koeffizienten ist dem Aufsatz "MOS Digital Filter Design" von W. Ulbrich auf den Seiten 236 - 271 des Buches "Design of MOS VLSI Circuits for Telecommunications", herausgegeben von Y. Tsividis und P. Antognetti, erschienen im Verlag Prentice-Hall, Inc., 1985, N.J. entnehmbar. Hier sei insbesondere auf die Figuren 9a und 10 sowie auf die zugehörige Beschreibung der Seiten 251 und 252 hingewiesen. Dieses bekannte Dezimierungsfilter wird in Schaltungen der digitalen Signalverarbeitung eingesetzt, um die Abtastrate der zu verarbeitenden Signale zu halbieren. Dabei wird der am Filtereingang angeordnete Multiplexer mit der Abtastrate der ihm zugeführten digitalisierten Signalwerte betrieben, während die an seine Ausgänge angeschlossenen Signalpfade und die mit diesen verbundenen Teilschaltungen des Filters mit der halben Abtastrate des Eingangssignals betrieben werden.

Der Erfindung liegt die Aufgabe zugrunde, ein digitales Dezimierungsfilter der eingangs genannten Art, jedoch mit programmierbaren Koeffizienten, anzugeben, das zur Halbierung der Abtastrate eines zu filternden Eingangssignals geeignet ist und auf einem dotierten Halbleiterkörper flächensparend integriert werden kann. Das wird erfindungsgemäß durch eine Ausbildung des Filters nach dem kennzeichnenden Teil des Patentanspruchs 1 erreicht.

Der mit der Erfindung erzielbare Vorteil liegt insbesondere darin, daß eine Mehrzahl von bitspezifischen Schaltungen, jeweils bestehend aus allen Partialproduktstufen, die zur Bewertung der Signalwerte nach den Filterkoeffizientenbits einer bestimmten Wertigkeit erforderlich sind, aus der zugeordneten Kettenschaltung sowie aus dem zugeordneten Paar von Signalpfaden, besonders flächensparend zu implementieren sind, so daß die Übertragungsfunktion des Filters auf einer kleineren Halbleiterfläche realisiert werden kann, als das bei dem oben erwähnten bekannten Dezimierungsfilter der Fall ist.

Die Erfindung wird nachfolgend anhand eines bevorzugten, in der Zeichnung schematisch dargestellten Ausführungsbeispiels näher erläutert.

Ein nach der Erfindung ausgebildetes Dezimierungsfilter enthält einen Multiplexer 1, dessen Eingang 2 auch den Filtereingang darstellt. Ein erster Ausgang 3 des Multiplexers 1 ist mit einem ersten Signalpfad 4 beschaltet, ein zweiter Ausgang 5 mit einem zweiten Signalpfad 6. 4 und 6 bilden ein erstes Paar von Signalpfaden. Ein Eingangssignal x wird dem Eingang 2 als eine Folge von abgetasteten, diskreten, digitalisierten Signalwerten xᵢ mit einer Abtastrate von 1/T zugeführt. Das bedeutet, daß während jeweils einer Abtastperiode T ein bestimmter Signalwert am Eingang 2 anliegt. Geht man z.B. von einem Signalwert xₙ aus, der während einer Abtastperiode Tₙ zugeführt wird, so ist der in der vorhergehenden Abtastperiode Tₙ₋₁ zugeführte Signalwert mit xₙ₋₁ zu bezeichnen, der in der davor liegenden Abtastperiode Tₙ₋₂ zugeführte mit xₙ₋₂, usw.. Der Multiplexer 1, der ebenfalls mit einer Abtastrate von 1/T arbeitet, führt die geradzahligen Signalwerte xₙ, xₙ₋₂ usw. dem Signalpfad 4 zu, die ungeradzahligen Abtastwerte xₙ₋₁, xₙ₋₃ usw. dem Signalpfad 6, so daß die Abtastrate an den Ausgängen 3 und 5 des Multiplexers jeweils 1/2T beträgt.

Da die bei 2 zugeführten digitalen Signalwerte eine Wortbreite von m Bit aufweisen, d.h. m-stellig sind, bestehen der Eingang 2 und die Ausgänge 3 und 5 jeweils aus m Anschlüssen. Die an die Ausgänge 3, 5 angeschlossenen Signalpfade 4 und 6 weisen dementsprechend jeweils m Leitungen auf, die zur bitparallelen Übertragung der Signalwerte xᵢ dienen.

Die Signalwerte xᵢ werden in einer Mehrzahl von Multiplizierern mit binären Filterkoeffizienten multipliziert bzw. bewertet. Jeder dieser Multiplizierer ist dabei in eine der Stellenzahl der binären Filterkoeffizienten entsprechende Zahl von Partialproduktstufen aufgeteilt, die jeweils eine Bewertung nach einem Koeffizientenbit vornehmen. Unter der Annahme, daß sechs Filterkoeffizienten c1 bis c6 vorgesehen sind, die jeweils eine Wortbreite von zwei Bit haben, wobei das am wenigsten signifikante Bit eine Wertigkeit von 2⁰ besitzt und die Wertigkeit des anderen Bits 2¹ beträgt, sind für die Bewertung mit dem Filterkoeffizienten c1, der aus den beiden Bits c1₁, c1₀ besteht, zwei Partialproduktstufen Mc1₁ und Mc1₀ vorgesehen. In analoger Weise sind für die Bewertung mit dem Filterkoeffizienten c2, der aus den beiden Bits c2₁, c2₀ besteht, zwei Partialproduktstufen Mc2₁ und Mc2₀ vorgesehen, usw..

Der Eingang 7 der Partialproduktstufe Mc6₀ für das am wenigstens signifikante Bit von c6 ist gemäß der Zeichnung mit dem Signalpfad 6 verbunden, während der Ausgang 8 von Mc6₀ über ein Verzögerungsglied 9 an den ersten Eingang eines Addierers 10 gelegt ist. Der Eingang 11 der für die Bewertung mit c5₀ vorgesehenen Partialproduktstufe Mc5₀ ist mit dem Signalpfad 4 verbunden, der Ausgang 12 dieser Stufe mit dem zweiten Eingang des Addierers 10. Der Ausgang des Addierers 10 ist über ein Verzögerungsglied 13 mit dem ersten Eingang eines Addierers 14 beschaltet. Der Eingang 15 einer Partialproduktstufe Mc4₀ liegt am Signalpfad 6, während der Ausgang 16 derselben mit dem zweiten Eingang des Addierers 14 beschaltet ist. Der Ausgang des Addierers 14 ist über ein Verzögerungsglied 17 mit dem ersten Eingang eines Addierers 18 verbunden. Der Eingang 19 einer Partialproduktstufe Mc3₀ liegt am Signalpfad 4, während der Ausgang 20 derselben am zweiten Eingang des Addierers 18 liegt. Weiterhin ist der Ausgang des Addierers 18 über ein Verzögerungsglied 21 mit dem ersten Eingang eines Addierers 22 verbunden. Der Eingang 23 einer Partialproduktstufe Mc2₀ liegt am Signalpfad 6, während der Ausgang 24 derselben an den zweiten Eingang des Addierers 22 geführt ist. Schließlich ist der Ausgang des Addierers 22 über ein Verzögerungsglied 25 mit dem ersten Eingang eines Addierers 26 verbunden. Der Eingang 27 einer Partialproduktstufe Mc1₀ liegt dabei am Signalpfad 4, während der Ausgang 28 derselben an den zweiten Eingang des Addierers 26 geführt ist. Der Ausgang des Addierers 26 ist über ein Verzögerungsglied 29 mit einem Anschluß 30 verbunden. Dieser stellt den Ausgang der aus den Teilen 9, 10, 13, 14, 17, 18, 21, 22, 25, 26 und 29 bestehenden Kettenschaltung dar. Weitere Anschlüsse 31 und 32 bilden die Ausgänge der Signalpfade 4 und 6.

Die Ein- und Ausgänge der vorstehend beschriebenen Partialproduktstufen Mc6₀ bis Mc1₀ bestehen wegen der zugeführten m-stelligen Signalwerte xᵢ aus jeweils m Anschlüssen. Auch die Anzahl der Ein- und Ausgänge der Addierer 10, 14, 18, 22 und 26 sowie der Verzögerungsglieder 9, 13, 17, 21, 25 und 29 richtet sich nach der Wortbreite m. Die Anschlüsse 31 und 32 weisen jeweils m Einzelanschlüsse auf, an denen die auf den Signalpfaden 4 und 6 übertragenen Signalwerte xᵢ bitparallel abgreifbar sind. Die mit den Ausgängen 12, 16, 20, 24 und 28 der genannten Partialproduktstufen verbundenen zweiten Eingänge der Addierer 10, 14, 18, 22 und 26 können auch als die freien Eingänge derselben bezeichnet werden, da die ersten Eingänge dieser Addierer jeweils zur Übernahme der innerhalb der obengenannten Kettenschaltung übertragenen Signale dienen.

Die beschriebenen Partialproduktstufen Mc6₀ bis Mc1₀, die zwischen den Schaltungspunkten 8 und 30 liegende Kettenschaltung und die Signalpfade 4 und 6 stellen eine bitspezifische Schaltung (bit plane) BP1 dar, die zur Multiplikation der Signalwerte xᵢ mit den Filterkoeffizientenbits niedrigster Wertigkeit c6₀ bis c1₀ vorgesehen ist. Werden die Addierer 10, 14, 18, 22 und 26 und die Partialproduktstufen Mc6₀ bis Mc1₀ zur Durchführung einer bitparallelen Signalverarbeitung in an sich bekannter Weise jeweils als zeilenförmige Anordnungen von Addiererstufen und Gatterschaltungen ausgebildet, so können sie in optimaler Weise flächensparend auf einem dotierten Halbleiterkörper integriert werden. Als besonders vorteilhaft erweist sich der Einsatz von Carry-Save-Addiererstufen oder von Carry-Ripple-Addiererstufen mit zusätzlichem Pipelining in der Übertragungsrichtung der Carry-Signale.

Für die Bewertung mit den Filterkoeffizientenbits c6₁ bis c1₁ der nächsthöheren Wertigkeit ist eine entsprechend aufgebaute bitspezifische Schaltung BP2 vorgesehen, die die Partialproduktstufen Mc6₁ bis Mc1₁ enthält. Hierbei sind jedoch die Signalpfade 33 und 34, die das zu BP2 gehörige Paar bilden, über Verzögerungsketten 35 und 36 mit den Anschlüssen 31 und 32 der Signalpfade 4 und 6 verbunden. Jede dieser Verzögerungsketten weist eine Anzahl von Verzögerungsgliedern auf, die der Anzahl der zwischen den Schaltungspunkten 8 und 30 angeordneten Verzögerungsglieder in BP1 entspricht. Im dargestellten Ausführungsbeispiel enthält also jede der Verzögerungsketten 35 und 36 sechs Verzögerungsglieder. Die Verzögerungsglieder 9, 13, 17, 21, 25 und 29 bewirken jeweils eine Signalverzögerung um eine halbe Taktperiode der an den Ausgängen 3 und 5 auftretenden Signalwerte, was einer Taktperiode der am Eingang 2 anliegenden Signalwerte xᵢ entspricht. Eine gleichgroße Signalverzögerung wird auch durch jedes einzelne Verzögerungsglied der Verzögerungsketten 35 und 36 erhalten. Damit ist sichergestellt, daß die am Ausgang 30 auftretenden, von BP1 gelieferten Zwischenergebnisse, die an BP2 weitergegeben werden, mit den von den Signalpfaden 4 und 6 auf die Signalpfade 32 und 34 übertragenen Signalwerten xᵢ synchronisiert sind.

In Abweichung von der bitspezifischen Schaltung BP1 enthält BP2 einen zusätzlichen Addierer 37, in dem die von Mc6₁ abgegebenen, bewerteten Signalwerte zu den am Schaltungspunkt 30 abgreifbaren Zwischenergebnissen addiert werden. Erst dieses Additionsergebnis wird dann über den Schaltungspunkt 8′ dem Eingang eines Verzögerungsgliedes 9′ zugeführt, das dem Verzögerungsglied 9 in BP1 entspricht. Auch die weiteren Teile der zwischen 8′ und 30′ angeordneten Kettenschaltung von BP2 entsprechen den gleichbezeichneten Teilen der zwischen 8 und 30 befindlichen Kettenschaltung von BP1, wobei die Bezugszeichen dieser Teile in BP2 durch einen Strich ergänzt sind. Der Ausgang 30′ der Kettenschaltung von BP2 bildet den Ausgang des in der Zeichnung dargestellten Dezimierungsfilters. An diesem ist das gefilterte Ausgangssignal abgreifbar, dessen Signalwerte eine Abtastrate aufweisen, die der halben Abtastrate der am Eingang 2 anliegenden Signalwerte xᵢ entspricht.

Bei einer Wortbreite der Filterkoeffizienten c6 bis c1 von jeweils p Bit, schließen sich an den Schaltungspunkten 23′, 27′ und 30′ weitere bitspezifische Schaltungen BP3 bis BPp an, die jeweils für eine getrennte Bewertung mit den weiteren, höherwertigen Filterkoeffizientenbits c6₃ bis c1₃ bzw. c6ₚ bis c1ₚ vorgesehen sind. Dementsprechend enthält BP3 die Partialproduktstufen Mc6₃ bis Mc1₃, während BPp die Stufen Mc6ₚ bis Mc1ₚ umfaßt. In diesem Fall stellt der Ausgang der zu BPp gehörenden Kettenschaltung den Filterausgang dar.

Die Verzögerungsglieder, z.B. 9, 13, 17, 21, 25 und 29, in den einzelnen Kettenschaltungen und die Verzögerungsglieder in den Verzögerungsketten, z.B. 35 und 36, sind als getaktete Registerhalbstufen, z.B. D-Flipflops ausgebildet, die jeweils eine Verzögerung der ihnen zugeführten Signalwerte um eine halbe Taktperiode der an den Ausgängen 3 und 5 auftretenden Signalwerte xᵢ bewirken.

## Patentansprüche

1. Digitales Dezimierungsfilter mit einem Multiplexer (1), dessen zwei Ausgänge (3, 5) mit einem ersten Paar von Signalpfaden (4, 6) beschaltet sind, wobei der erste Signalpfad (4) dieses Paares die nach der zeitlichen Reihenfolge numerierten geradzahligen Signalwerte eines dem Multiplexer (1) mit einer vorgegebenen Abtastrate zugeführten Eingangssignals und der zweite Signalpfad (6) die nach der zeitlichen Reihenfolge numerierten ungeradzahligen Signalwerte übernimmt, mit Multiplizierern, die die Signalwerte mit einer Mehrzahl von binären Filterkoeffizienten (c6...c1) bewerten und mit einer Mehrzahl von in einer ersten Kettenschaltung angeordneten ersten Addierern (10, 14, 18, 22, 26) die zur Addition der bewerteten Signalwerte dienen, **dadurch gekennzeichnet**, daß die Stellenzahl der binären Filterkoeffizienten (c6 ... c1) mindestens zwei beträgt, daß jeder Multiplizierer in eine der Stellenzahl der binären Filterkoeffizienten (c6...c1) entsprechende Zahl von Partialproduktstufen (Mc6₀, Mc6₁...Mc1₀, Mc1₁) aufgeteilt ist, die jeweils eine Bewertung nach einem Filterkoeffizientenbit vornehmen, daß die nach den Filterkoeffizientenbits niedrigster Wertigkeit (c6₀...c1₀) bewertenden Partialproduktstufen (Mc6₀...Mc1₀) zwischen die Signalpfade (4, 6) des ersten Paares und die freien Eingänge der ersten Addierer (10, 14, 18, 22, 26) geschaltet sind, wobei zwischen die einzelnen ersten Addierer jeweils erste Verzögerungsglieder (13, 17, 21, 25) eingefügt sind, daß für jedes weitere Filterkoeffizientenbit (c6₁...c1₁) einer höheren Wertigkeit ein weiteres Paar von Signalpfaden (33, 34) vorgesehen ist, welche über Verzögerungsketten (35, 36) an die Signalpfade (4, 6) des jeweils vorhergehenden Paares angeschlossen sind, daß für jedes dieser weiteren Filterkoeffizientenbits (c6₁...c1₁) eine weitere, entsprechend aufgebaute Kettenschaltung (8′...30′) mit weiteren Addierern (10′, 14′, 18′, 22′, 26′) unmittelbar an den Ausgang (30) der vorhergehenden Kettenschaltung (8...30) angeschaltet ist, daß für jedes dieser weiteren Filterkoeffizientenbits (c6₁...c1₁) die nach diesem Filterkoeffizientenbit bewertenden Partialproduktstufen (Mc6₁...Mc1₁) zwischen die Signalpfade (33, 34) der weiteren Paares und die freien Eingänge der weiteren Addierer (10′, 14′, 18′, 22′, 26′) geschaltet sind, wobei zwischen die weiteren Addierer jeweils weitere Verzögerungsglieder (13′, 17′, 21′, 25′) eingefügt sind, und daß der Ausgang (30′) der zu dem Filterkoeffizientenbit höchster Wertigkeit gehörenden Kettenschaltung (8′...30′) den Filterausgang darstellt.

## Claims

1. Digital decimation filter having a multiplexer (1), the two outputs (3, 5) of which are connected to a first pair of signal paths (4, 6), in which the first signal path (4) of this pair receives the even numbered signal values, numbered in accordance with the temporal sequence, of an input signal fed to the multiplexer (1) at a prescribed sampling rate and the second signal path (6) receives the odd numbered signal values, numbered in accordance with the temporal sequence, having multipliers which weight the signal values with a plurality of binary filter coefficients (c6 ... c1) and having a plurality of first adders (10, 14, 18, 22, 26), which are disposed in a first iterative circuit and which serve for the addition of the weighted signal values, characterized in that the place number of the binary filter coefficients (c6 ... c1) is at least two, in that each multiplier is divided into a number of partial product stages (Mc6₀, Mc6₁ ... Mc1₀, Mc1₁) which corresponds to the place number of the binary filter coefficients (c6 ... c1), which partial product stages undertake in each instance a weighting according to one filter coefficient bit, in that the partial product stages (Mc6₀ ... Mc1₀) weighting according to the filter coefficient bits of lowest significance (c6₀ ... c1₀) are connected between the signal paths (4, 6) of the first pair and the free inputs of the first adders (10, 14, 18, 22, 26), in which first delay elements (13, 17, 21, 25) are inserted in each instance between the individual first adders, in that for each further filter coefficient bit (c6₁ ... c1₁) of a higher significance a further pair of signal paths (33, 34) is provided, which are connected via delay chains (35, 36) to the signal paths (4, 6) of the respectively preceding pair, in that for each one of these further filter coefficient bits (c6₁ ... c1₁) a further, correspondingly constructed iterative circuit (8′ ... 30′) with further adders (10′, 14′, 18′, 22′, 26′) is directly connected to the output (30) of the preceding iterative circuit (8 ... 30), in that for each one of these further filter coefficient bits (c6₁ ... c1₁) the partial product stages (Mc6₁ ... Mc1₁) weighting according to this filter coefficient bit are connected between the signal paths (33, 34) of the further pair and the free inputs of the further adders (10′, 14′, 18′, 22′, 26′), in which further delay elements (13′, 17′, 21′, 25′) are inserted in each instance between the further adders, and in that the output (30′) of the iterative circuit (8′ ... 30′) belonging to the filter coefficient bit of highest significance represents the filter output.

## Revendications

1. Filtre numérique à décimation comportant un multiplexeur (1), dont les deux entrées (3, 5) sont connectées à une première paire de voies (4, 6) de transmission de signaux, la première voie (4) de transmission de signal de cette paire prenant en charge les valeurs de signal d'ordre pair numérotées suivant la succession temporelle, d'un signal d'entrée envoyé au multiplexeur (1) à un taux d'échantillonnage prescrit et la seconde voie (6) de transmission de signal prenant en charge les valeurs de signal d'ordre impair numérotées suivant la succession temporelle, le filtre comportant des multiplicateurs, qui pondèrent les valeurs de signal par une pluralité de coefficients (c6 ... c1) binaires de filtre et une pluralité de premiers additionneurs (10, 14, 18, 22, 26), qui sont disposés dans un premier circuit en chaîne et qui servent à additionner les valeurs de signal pondérées, caractérisé en ce que le nombre de bits des coefficients (c6 ... c1) binaires de filtre est au moins de deux, chaque multiplicateur est subdivisé en un nombre d'étages (Mc6₀, Mc6₁ ... Mc1₀, Mc1₁) de produit partiel qui correspond au nombre de bits des coefficients (c6₀ ... c6₁) binaires de filtre, ces étages effectuant une pondération suivant un bit de coefficient de filtre, les étages (Mc6₀ ... Mc1₀) de produit partiel, qui sont de plus faible poids (c6₀ ... c1₀) suivant les bits de coefficient de filtre, sont branchés entre les voies (4, 6) de transmission de signaux de la première paire et les entrées libres du premier additionneur (10, 14, 18, 22, 26), des premiers circuits (13, 17, 21, 25) à retard étant insérés entre les différents premiers additionneurs, pour chaque bit (c6₁ ... c1₁) suivant de coefficient de filtre ayant un poids plus grand, est prévu une autre paire de voies (33, 34) de transmission de signaux, qui sont connectées par l'intermédiaire de chaînes (35, 36) à retard aux voies (4, 6) de transmission de signaux de la paire respectivement précédente, un autre circuit (8′ 30′), qui a une structure correspondante et qui comporte d'autres additionneurs (10′, 14′, 18′, 22′, 26′), est connecté directement pour chacun des autres bits (c6₁ ... c1₁) de coefficient de filtre, à la sortie (30) du circuit (8 ... 30) à retard précédent, pour chacun des autres bits (c6₁ ... c1₁) de coefficient de filtre les étages (Mc6₁ ... Mc1₁) de produit partiel ayant le poids de ce bit de coefficient de filtre sont branchés entre les voies (33, 34) de transmission de signaux de l'autre paire et les entrées libres des autres additionneurs (10′, 14′, 18′, 22′, 26′), d'autres circuits (13′, 17′, 21′, 25′) à retard étant insérés respectivement entre les autres additionneurs, et la sortie (30′) du circuit (8′... 30′) en chaîne ayant le bit de coefficient de filtre de poids le plus fort représentant la sortie du filtre.
